# EUROPEAN PATENT APPLICATION

(11) **EP 2 955 749 A1**
(43) Date of publication of application: **16.12.2015**
(21) Application number: 14171778.5
(22) Date of filing: 10.06.2014
(51) Int. Cl.: H01L 23/373, H01L 23/42

(54) **A method of heat transfer in power electronics applications**

(71) Applicant: ABB Technology Oy, 00380 Helsinki (FI)
(72) Inventor: Silvennoinen, Mika, 00380 HELSINKI (FI); Martinmaa, Juha, 00380 Helsinki (FI); Mörsky, Heikki, 00380 Helsinki (FI)
(74) Representative: Kolster Oy Ab

(57) **Abstract**

The invention relates to a method of heat transfer in power electronics applications is disclosed, wherein a metal foil comprising at least about 50% of tin, based on a total amount of metals contained in the metal foil, is used as a thermal interface material between a base plate of a heat-generating component and a heat sink. The invention also relates to a method for producing a power electronics assembly, comprising the steps of: disposing a metal foil comprising at least about 50% of tin, based on a total amount of metals contained in the metal foil on a heat sink; disposing a base plate of a heat generating component or module on the heat sink covered by the metal foil to provide a power electronics device; applying a clamping force to the power electronics assembly to provide a cooled power electronics assembly.

## Description

### FIELD OF THE INVENTION

The present invention relates to a method of heat transfer in power electronics applications. More particularly, the invention relates to a use of a metal foil as a thermal interface material in power electronics applications.

### BACKGROUND OF THE INVENTION

Power electronic components and modules that are used in power electronic devices for switching typically high currents need to be kept below a certain temperature. A power electronic module contains multiple of switch components, such as power diodes or insulated gate bipolar transistors (IGBT). An example of a device containing power electronic components is an inverter. Inverters produce alternating voltage by switching DC voltage pulses in a high frequency to a load. Each time the switches of an inverter are operated, a relatively large power is dissipated in the switches.

Typically the base plate of the component or the module is thermally connected to a heat sink such that the heat generated in the module or component is lead through the baseplate to the heat sink. Thermal interface materials (TIMs) are commonly provided to establish heat transfer from the baseplate of the heat-generating component or module to a heat sink. There are a large variety of TIMs commonly used in these applications, including thermal greases, phase change materials, thermal tapes and metal foils.

WO 2007/050712 A2 discloses a thermally conductive patterned metal foil for facilitating heat dissipation from an integrated circuit device to a heat sink. The metal foil is formed of an alloy of lead, indium, tin and other malleable metals.

Also, metallic TIMs based on an indium metal are known in IGBT applications. An example of such TIMs is commercially available Heat-Spring^{®} products in a form of metal foil from Indium Corporation. A drawback of the Heat-Spring products is that they are expensive due to the large amount of indium included in the foil. Further, the large amount of indium in the foil makes the foil brittle, and therefore the mounting of the foil between the heat sink and the base plate of the module has to be carried out with care as the brittle foil brakes easily during the mounting.

There is a need for an inexpensive, efficient, reliable, stable, easy-to-handle thermal interface material suitable for use in power electronics applications.

### BRIEF DESCRIPTION OF THE INVENTION

An object of the invention is to provide a method of heat transfer in power electronics applications, wherein a metal foil comprising at least about 50% of tin, based on a total amount of metals contained in the metal foil, is used as a thermal interface material between a base plate of a heat-generating component and a heat sink.

Another object of the invention is a method for producing a power electronics assembly, comprising the steps of:
- disposing a metal foil comprising at least about 50% of tin, based on a total amount of metals contained in the metal foil,
- disposing a base plate of a heat generating component or module on the heat sink covered by the metal foil to provide a power electronics device,
- applying a clamping force to the power electronics assembly to provide a cooled power electronics assembly.

A further object of the invention is a use of a metal foil, comprising at least about 50% of tin, specifically at least about 90% of tin, more specifically at least about 99.9% of tin, based on a total amount of metals contained in the metal foil, for heat transfer in power electronics applications.

It was surprisingly found that the same effect of a prior art indium-based metal foil in power electronics applications is achieved with a metal foil containing a large amount of more inexpensive tin. Indium has a better thermal conductivity than tin and needs no high clamping force applied in the power electronics application. Good heat transfer characteristics of a tin-based metal foil are achieved as long as the clamping force applied is sufficient.

The invention provides an improved means for heat transfer in power electronic application by means of a metal foil. The metal foil used in the invention is inexpensive, efficient, reliable, stable, easy-to-handle thermal interface material which can be easily mounted between the base plate of the cooled component or module and a heat sink. The metal foil does not exhibit a pump-out phenomenon typically occurred with viscous TIMs.

### BRIEF DESCRIPTION OF THE DRAWINGS

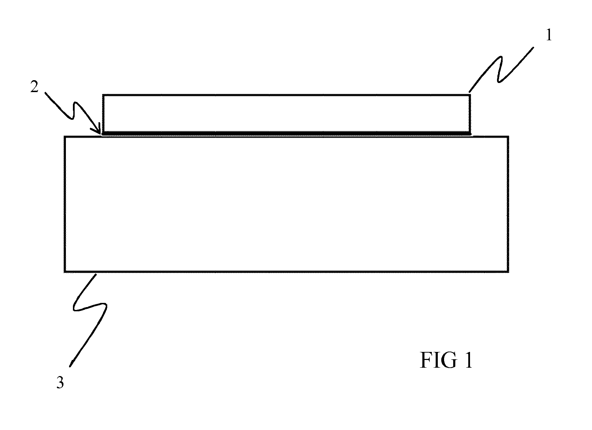

Figure 1 illustrates a simplified example of an assembly including an IGBT module, a heat transfer metal foil of the invention and a heat sink.

### DETAILED DESCRIPTION OF THE INVENTION

An object of the invention is to provide a method of heat transfer in power electronics applications, wherein a metal foil comprising at least about 50% of tin, based on a total amount of metals contained in the metal foil, is used as a thermal interface material between a base plate of a heat-generating component and a heat sink.

In an embodiment, the metal foil comprises at least about 90% of tin, based on a total amount of metals contained in the metal foil. In another embodiment, the metal foil comprises at least about 99.9% of tin, based on a total amount of metals contained in the metal foil.

In addition to tin (Sn), the metal foil comprises one or more other malleable metals. In an embodiment, an amount of the other malleable metals is at most of about 50%. In another embodiment, the amount is at most of about 10%. In a further embodiment, the amount is at most of about 0.1%. In an embodiment, the other malleable metals are selected from a group consisting of silver (Ag), aluminium (Al), arsenic (As), gold (Au), bismuth (Bi), cadmium (Cd), chromium (Cr), copper (Cu), iron (Fe), mercury (Hg), indium (In), nickel (Ni), lead (Pb) and a mixture thereof.

The metal foil has a characteristic softness and formability which allows the metal foil to be well conformed to the surface irregularities.

The metal foil used in the invention is free of fat and oil.

The metal foil can be provided as a monolayer or a multilayer foil. When the metal foil comprises more than one layer, the composition of the layers can be similar to or different from each other. In an embodiment, the metal foil is a monolayer foil.

In an embodiment, at least one outer surface of the metal foil is patterned. The metal foil can have various types of patterned surfaces. Suitable patterned surfaces are described for example in WO 2007/050712 A2. The patterned surface can be uniform or non-uniform. The one-sided or double-sided patterned surfaces facilitate the metal foil to better adapt to the irregularities of the surfaces with which the metal foil is attached. The patterned surface(s) thus provide(s) enhanced heat dissipation from a heat-generating component to a heat sink.

The metal foil typically has a thickness in the range of about 50 µm to about 200 µm. In an embodiment, the thickness is in the range of about 100 µm to about 150 µm. In another embodiment, the thickness is about 150 µm.

In an embodiment, the metal foil is provided in a form of a roll.

The metal foil can be used in any power electronics application where a thermal interface material for heat transfer from a heat-generating component or module to a heat sink is needed. In an embodiment, the heat-generating component is an insulated gate bipolar transistor (IGBT). In another embodiment, the heat generating module is a power electronics module containing one or multiple of electronic switch components, such as diodes or IG-BTs.

Figure 1 illustrates a simplified example of an assembly comprising an IGBT module 1, a heat sink 3 and a heat transfer metal foil 2 of the invention disposed between the module 1 and the heat sink 3. The module and the heat sink are attached to each other by means of mechanical fastening. Typically heat sinks are provided with threaded holes to match through holes made in the base plate of the module. The heat transferring metal foil comprises also holes for attachment such that when the metal foil is placed on top of the base plate, the threaded holes of the heat sink, the holes of the metal foil and the holes of the base plate are at the same position allowing a screw to penetrate through the holes. Instead of providing threaded holes to the heat sink, trough holes can be made, whereby the attachment of is carried out by a bolt and a nut attachment.

For the heat transfer to be effective, the tightening torque of the screws or bolts should be high enough so that a desired pressure or clamping force is obtained between the heat sink and the base plate. The thermal resistance of the metal foil drops in proportion to the applied pressure. For the known indium-based metal foil a pressure of approximately 50 psi is required whereas for a tin-based metal foil the needed pressure is approximately in the range of about 100 psi to about 150 psi. Typical tightening torque of the screws or bolts is in the range of 1 to 6 Nm for obtaining desired pressure.

Holes for attachment of the base plate and the heat sink are provided typically to the corners of the module. In larger modules screw holes can also be situated on the sides of the module such that the longer dimension of the module may have four holes evenly distributed making together eight attachment points, for example.

For providing evenly distributed pressure between the base plate and the heat sink, the metal foil is preferably thicker in the areas between the attachment points. Although the base plate and the heat sink are rigid component, the base plate may bend during the use due to temperature changes, for example. The bending of the base plate affects the heat transfer as the pressure between the base plate and the heat sink may change. When the metal foil is made thicker in the areas between the attachment points, the heat transfer is not hindered as much as with a foil with a uniform thickness. The thickness of the metal foil can vary at most of about 100% in the range of about 50 µm to about 200 µm.

Another object of the invention is to provide a method for producing a power electronics assembly, comprising the steps of:
- disposing a metal foil comprising at least about 50% of tin, based on a total amount of metals contained in the metal foil on a heat sink,
- disposing a base plate of a heat generating component or module on the heat sink covered by the metal foil,
- applying a clamping force to the power electronics assembly.

A further object of the invention is a use of metal foil, comprising at least about 50% of tin, based on a total amount of metals contained in the metal foil, for heat transfer in power electronics applications. In an embodiment, the metal foil comprises at least about 90% of tin. In another embodiment, the metal foil comprises about 99.9% of tin.

### Example

Temperature of a baseplate of an IGBT module was measured below an IGBT component and below its parallel diode. Table 1 shows that the temperatures of the two components achieved with the metal foil of the invention are essentially similar to those achieved with prior art metal foils, indicating an excellent performance of the metal foil of the invention as a thermal interface material in a power electronics application.

**Table 1.**

| | In52%/Sn48% | In 99.9% | Sn 99.9% (invention) |
|---|---|---|---|
| Air In (Temp. °C) | 40.0 | 40.0 | 40.0 |
| IGBT (Temp. °C) | 117.0 | 117.1 | 118.9 |
| DIODE (Temp. °C) | 120.3 | 119.9 | 121.8 |

It will be obvious to a person skilled in the art that, as the technology advances, the inventive concept can be implemented in various ways. The invention and its embodiments are not limited to the examples described above but may vary within the scope of the claims.

## Claims

1. A method of heat transfer in power electronics applications, wherein a metal foil comprising at least about 50% of tin, based on a total amount of metals contained in the metal foil, is used as a thermal interface material between a base plate of a heat-generating component and a heat sink.

2. The method of claim 1, wherein the metal foil comprises at least about 90% of tin, specifically at least about 90% of tin, more specifically at least about 99.9% of tin.

3. The method of claim 1 or 2, wherein the metal foil further comprises one or more metals selected from a group consisting of silver, aluminium, arsenic, gold, bismuth, cadmium, chromium, copper, iron, mercury, indium, nickel, lead and a mixture thereof.

4. The method of any one of the preceding claims, wherein the metal foil is fat-free and oil-free.

5. The method of any one of the preceding claims, wherein the metal foil comprises one or more layers, the composition of which can be similar to or different from each other.

6. The method of any one of the preceding claims, wherein at least one outer surface of the metal foil is patterned.

7. The method of any one of the preceding claims, wherein the metal foil has a thickness in the range of about 50 µm to about 200 µm, specifically in the range of about 100 µm to about 150 µm, more specifically about 150 µm.

8. The method of claim 7, wherein the thickness of the metal foil varies at most of about 100%.

9. The method of any one of the preceding claims, wherein the metal foil is provided in a form of a roll.

10. The method of any one of the preceding claims, wherein the heat generating component is an insulated gate bipolar transistor (IGBT).

11. A method for producing a power electronics assembly, comprising the steps of:
- disposing a metal foil comprising at least about 50% of tin, based on a total amount of metals contained in the metal foil, defined in any one of claims 1 to 10, on a heat sink,
- disposing a base plate of a heat generating component or module on the heat sink covered by the metal foil to provide a power electronics device,
- applying a clamping force to the power electronics assembly to provide a cooled power electronics assembly.

12. A use of a metal foil comprising at least about 50% of tin, specifically at least about 90% of tin, more specifically at least about 99.9% of tin, based on a total amount of metals contained in the metal foil, for heat transfer in power electronics applications.
